# EUROPÄISCHE PATENTSCHRIFT

(11) **EP 0 977 281 B1**
(45) Veröffentlichungstag und Bekanntmachung des Hinweises auf die Patenterteilung: **14.02.2007**
(21) Anmeldenummer: 99114555.8
(22) Anmeldetag: 24.07.1999
(51) Int. Cl.: H01L 39/14

(54) **Hoch-Tc-Wechselstrommehrkernsupraleiter sowie Verfahren zu dessen Herstellung**
High Tc multifilament superconductor for alternating current and method of making the same
Supraconducteur multibrins à haute température pour courant alternatif et procédé de sa fabriction

(30) Priorität: 28.07.1998 DE 19833918
(43) Veröffentlichungstag der Anmeldung: 02.02.2000
(73) Patentinhaber: Nexans SuperConductors GmbH, 50351 Huerth (DE)
(72) Erfinder: Bock, Joachim Dr., 50374 Erftstadt (DE); Bäcker, Michael Dr., 50677 Köln (DE); Fischer, Bernhard, Dr., 63486 Bruchköbel (DE); Müller, Jens, 42897 Remscheid (DE); Kautz, Stefan, 90607 Rückersdorf (DE)
(74) Vertreter: Feray, Valérie

(56) Entgegenhaltungen:
- EP-A- 0 867 950
- WO-A-98/13859

## Beschreibung

Die Erfindung bezieht sich auf einen Wechselstrom-Supraleiter mit mehreren Leiterkernen, welche jeweils
- ein Supraleitermaterial mit einer metalloxidischen Hoch-T_{c}-Phase auf Basis eines Bi-Cuprates aufweisen,
- in ein Ag zumindest enthaltendes Matrixmaterial eingebettet sind und
- von einer Umhüllung umgeben sind, die aus einem metalloxidischen Material mit einem gegenüber dem Matrixmaterial vergleichsweise größeren spezifischen elektrischen Widerstand bestehen.

Die Erfindung betrifft ferner ein Verfahren zur Herstellung eines solchen Mehrkemsupraleiters. Ein entsprechender Mehrkernsupraleiter mit diesen Merkmalen sowie ein Verfahren zu seiner Herstellung gehen aus der *WO96*/*28853* hervor.

Es sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und insbesondere eine LN₂-Kühltechnik erlauben. Unter solche Metalloxidverbindungen fallen insbesondere Cuprate des speziellen Stoffsystems vom Grundtyp Bi-Sr-Ca-Cu-O. Innerhalb dieses Stoffsystems treten mehrere supraleitende Hoch-T_{c}-Phasen auf, die sich durch die Anzahl ihrer Kupfer-Sauerstoff-Netzebenen bzw. - Schichten innerhalb der kristallinen Einheitszelle unterscheiden und die verschiedene Sprungtemperaturen T_{c} aufweisen. So sind eine Phase mit einer Sprungtemperatur von etwa 80 K der Zusammensetzung Bi₂Sr₂CaCu₂O_{y} (80 K-Phase, 2-Schichter oder 2212-Phase) und eine Phase mit einer Sprungtemperatur von etwa 110K der Zusammensetzung Bi₂Sr₂Ca₂Cu₃Oₓ (110 K-Phase, 3-Schichter oder 2223-Phase) bekannt. Insbesondere bei letzterer Phase kann die Bi-Komponente durch Pb partiell substituiert sein.

Mit diesen HTS-Materialien wird versucht, langgestreckte Supraleiter in Draht- oder Bandform herzustellen. Ein hierfür als geeignet angesehener Verfahrensschritt ist die sogenannte "Pulver-im-Rohr-Technik", die prinzipiell von der Herstellung von Supraleitern mit dem klassischen metallischen Supraleitermaterial Nb₃Sn her bekannt ist. Entsprechend dieser Technik wird auch zur Herstellung von Leitern aus dem genannten HTS-Material in eine rohrförmige Hülle bzw. in eine Matrix aus einem normalleitenden Material, insbesondere aus Ag oder einem Ag-haltigen Material, Pulver aus einem Vormaterial (sogenanntes "Precursor"-Material) eingebracht, das im allgemeinen noch nicht oder nur zu einem geringen Teil die gewünschte supraleitende Hoch-T_{c}-Phase enthält. Der so zu erhaltende Aufbau wird anschließend mittels einer mehrere Verformungsschritte einschließenden Verformungsbehandlung, die gegebenenfalls durch mindestens einen Wärmebehandlungsschritt bei erhöhter Temperatur unterbrochen sein können, auf die gewünschte Enddimension gebracht. Danach wird das so erhaltene Leiterzwischenprodukt zur Einstellung oder Optimierung seiner supraleitenden Eigenschaften bzw. zur Ausbildung der gewünschten Hoch-T_{c}-Phase noch mindestens einem Glühschritt unterzogen. Dieser Glühschritt wird wenigstens teilweise in einer sauerstoffhaltigen Atmosphäre bei erhöhter Temperatur durchgeführt, die im Falle des Stoffsystems (Bi,Pb)-Sr-Ca-Cu-O bei Glühung an Luft im allgemeinen zwischen 835° C und 840° C und bei reduziertem Sauerstoffpartialdruck bei etwa 815° C liegt (vgl. z.B. auch *"Supercond. Sci. Technol.", Vol. 4,* 1991, *Seiten* 165 *bis 171).*

Bündelt man in an sich bekannter Weise mehrere entsprechenden Hoch-T_{c}-Supraleiter oder Vorformen dieser Leiter, so kann man auch ein Endprodukt mit mehreren supraleitenden Leiterkernen, einen sogenannten Mehrkern- oder Multifilamentleiter, erhalten (vgl. auch *"IEEE Transactions on Applied Superconductivity", Vol. 5, No. 2, Juni 1995, Seiten 1145 bis 1149 oder 1259 bis 1261)*. Insbesondere für Wechselstrom(AC)-Anwendungen kann das Bündel von einzelnen Leiterkernen um die gemeinsame Leiterachse verdrillt (getwistet) werden.

Es zeigt sich jedoch, daß entsprechende Mehrkernleiter bei AC-Anwendungen über die elektrisch gut leitende Matrix verhältnismäßig große AC-Verluste erzeugen, die zu einer Beeinträchtigung der supraleitenden Eigenschaften des Leiters führen können. Gemäß der eingangs genannten WO-Schrift wird deshalb eine elektrisch schlecht-leitende oder isolierende Umhüllung bzw. Barriere um jeden einzelnen Leiterkem vorgesehen. Als Materialien sollen dabei Oxide von metallischen Elementen wie z.B. Cu oder Al oder Zr eingesetzt werden. Auch Gemische aus mehreren dieser Oxiden werden als geeignet betrachtet. Die entsprechenden Umhüllungen werden durch Verwendung von oxidischen Materialien von vornherein realisiert oder durch nachträgliche Oxidation der entsprechenden metallischen Elemente ausgebildet.

Derartige Umhüllungen oder Barrieren in AC-Mehrkemsupraleitem der eingangs genannten Art müssen neben dem Erfordernis einer geringen elektrischen Leitfähigkeit unter anderem auch die Forderung erfüllen, daß sie keine Diffusionsbarrieren für einen Sauerstofftransport durch die Matrix darstellen, der für die Bildung der gewünschten supraleitenden Hoch-T_{c}-Phase des Bi-Cuprates notwendig ist. Darüber hinaus dürfen sie keine unerwünschten Reaktionen mit den Komponenten des HTS-Materials eingehen, die zu einer Beeinträchtigung der supraleitenden Eigenschaften führen könnten. Auch sollen sie bei Verformungsprozessen ihr Umformverhalten praktisch nicht ändern.

Aufgabe der vorliegenden Erfindung ist es, ein Material für solche Umhüllungen anzugeben, mit dem die genannten Forderungen zu erfüllen sind. Außerdem soll ein Verfahren zur Herstellung eines Mehrkernsupraleiters und insbesondere zur Ausbildung einer solchen Umhüllung angegeben werden.

Diese Aufgabe wird bezüglich des Mehrkernsupraleiters mit den eingangs genannten Merkmalen dadurch gelöst, daß als Material der Umhüllung ein Bi_{1,8-2,2}Sr_{1,8-2,2}Cu_{0,8-1,2}Oₓ oder (Sr_{α}Ca_{1-α})Cu_{y}O_{z} (mit 0,1 ≤ α ≤ 0,9 und 0,3 ≤ y ≤ 3) zumindest enthaltendes, nicht-supraleitendes Bi-Sr- oder Sr-Ca- Cupratmaterial vorgesehen ist und im Fall des Bi-Sr-Caprats das Material der Umhüllungs einen Gehalt an Fremdphasen von mehr als 0 Gewichtsprozent bis zu 50 Gewichtsprozent gegenüber Bi_{1,8-2,2} Sr_{1,8-2,2} Cu_{0,8-1,2} Ox aufweist. Die nicht-supraleitenden Cuprate stellen jeweils nur einen Grundtyp dar, der eine an sich bekannte teilweise Substitution einzelner Komponenten dieser Materialien sowie Abweichungen von der exakten Stöchiometrie mit einschließen soll. Die Sauerstoffindizes sind allgemein bekannt.

Die mit dieser Ausgestaltung des Mehrkernsupraleiters verbundenen Vorteile sind darin zu sehen, daß bei Verwendung von Umhüllungen aus den genannten Materialien einerseits keine Beeinträchtigung des Supraleitermaterials und des Sauerstofftransports zu beobachten ist und daß andererseits bei einer gemeinsamen Verformung von mehreren entsprechend umhüllten Leiterkernen das Umformverhalten der Umhüllungen und des gesamten Leiteraufbaus praktisch unverändert bleibt.

Diese Eigenschaften der Umhüllungsmaterialien kommen insbesondere bei Mehrkemsupraleitem zu tragen, die zumindest zu einem überwiegenden Anteil, d.h. zu mehr als 80 Gew.-%, vorzugsweise zu mehr als 90 Gew.-%, die 2223-Phase aufweisen sollen.

Darüber hinaus sind die genannten Eigenschaften des erfindungsgemäßen Umhüllungsmaterials, insbesondere die gute Umformungseigenschaft, von Vorteil, wenn der Mehrkernsupraleiter eine Bandform aufweisen soll.

Ein Verfahren zur Herstellung des Mehrkernsupraleiters nach der Erfindung ist dadurch gekennzeichnet, daß Leiterelemente mit jeweils einem von dem Matrixmaterial umgebenen Kern aus einem Vormaterial des Supraleitermaterials ausgebildet werden, die einem das Vormaterial verdichtenden Verformungsprozeß und gegebenenfalls einer Glühbehandlung unterzogen werden, daß dann diese Leiterelemente jeweils mit einem Überzug aus dem Material der Umhüllung versehen werden, und daß anschließend mit einem Bündel aus umhüllten Leiterelementen ein Mehrkemrohleiter gebildet wird, der mittels einer Verformungs- und Glühbehandlung in ein Leiterendprodukt überführt wird. Dabei können vorteilhaft die Leiterelemente durch ein Bad einer Schmelze des Umhüllungsmaterials gezogen werden. Die Schmelztemperatur des Umhüllungsmaterials kann nämlich deutlich unter der Glühtemperatur (Sintertemperatur) zur Ausbildung der gewünschten Hoch-T_{c}-Phase gehalten werden, so daß dann eine Änderung der Phasenzusammensetzung nicht zu befürchten ist.

Statt des gewünschten, endgültigen Umhüllungsmaterials kann für das Bad der Schmelze auch ein Materialvorprodukt vorgesehen werden, das während des Ziehens oder nach dem Ziehen der Leiterelemente durch die Schmelze einer Oxidationsbehandlung unterzogen wird, um so das endgültige, oxidische Umhüllungsmaterial auszubilden.

Gemäß einer weiteren Verfahrensvariante werden zum Überziehen der Leiterelemente diese durch eine ein feinpulvriges Umhüllungsmaterial oder ein Materialvorprodukt desselben enthaltende Suspension gezogen und wird das anhaftende Pulver anschließend in einer Heizzone aufgeschmolzen. Auch hier ist es möglich, das Materialvorprodukt vor dem Aufschmelzen in der Heizzone oder während des Aufschmelzens einer Oxidationsbehandlung zu unterziehen. Auch mit dieser weiteren Verfahrensvariante ist ein vorteilhaft einfach durchzuführendes Umhüllen der Leiterelemente möglich.

Weitere vorteilhafte Ausgestaltungen des erfindungsgemäßen Mehrkernsupraleiters bzw. des Verfahrens zu seiner Herstellung gehen aus den jeweils abhängigen Ansprüchen hervor.

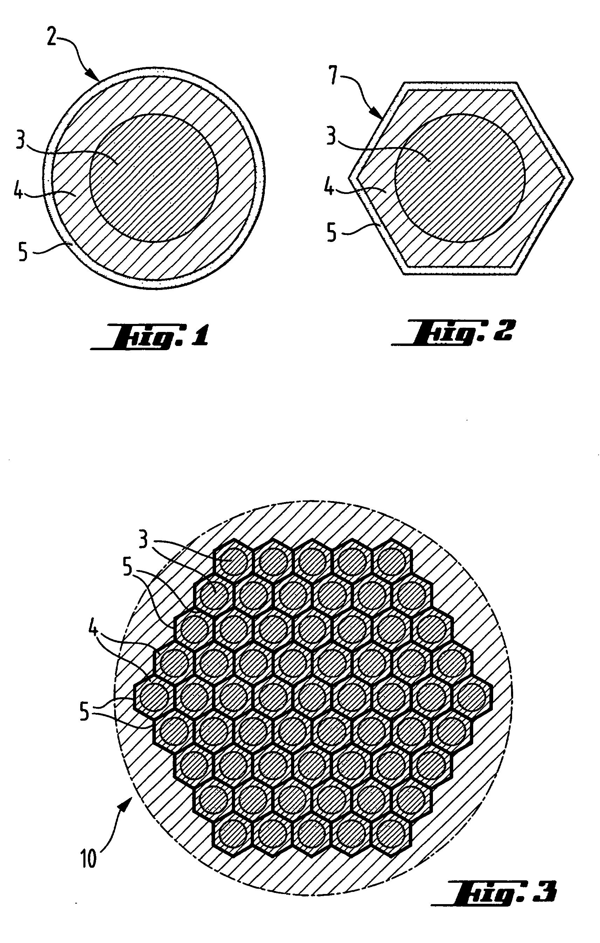

Die Erfindung wird nachfolgend anhand eines bevorzugten Ausführungsbeispieles noch weiter erläutert. Dabei wird auf die Zeichnung Bezug genommen,
- deren Figuren 1 und 2 je ein Leiterelement zum Aufbau eines erfindungsgemäßen Mehrkernsupraleiters
   und
- deren Figur 3 einen mit mehreren solchen Leiterelementen aufgebauten Mehrkemrohleiter als Zwischenprodukt bei der Herstellung des Mehrkernsupraleiters jeweils schematisch im Querschnitt zeigen. Dabei sind in den Figuren sich entsprechende Teile mit denselben Bezugszeichen versehen.

Figur 1 zeigt ein entsprechendes, allgemein mit 2 bezeichnetes Leiterelement. Sein zentraler Kern 3 besteht aus dem HTS-Vormaterial und ist von einer Ag-Hülle 4 umschlossen. Dieser Aufbau ist noch mit einer erfindungsgemäßen Umhüllung 5 versehen. Als Material dieser Umhüllung kommen nicht-supraleitende Cuprate auf Basis von Bi_{1,8-2,2}Sr_{1,8-2,2}Cu_{0,8-1,2}Oₓ oder (Sr_{α}Ca_{1-α})Cu_{y}O_{z} (mit 0,1 ≤ α ≤ 0,9 und 0,3 ≤ y ≤ 3 in Frage. Diese Materialien stellen jeweils nur einen Grundtyp dar: D.h., einzelne ihrer Komponenten können in an sich bekannter Weise durch weitere Komponenten partiell substituiert sein. Für die Substitution kommen insbesondere andere Erdalkalimaterialien, insbesondere Ca, oder auch Pb oder Sb in Frage. So ist es z.B. bei einer beabsichtigten Ausbildung einer Hoch-T_{c}-Phase des Supraleitermaterials der Zusammensetzung (Bi,Pb)₂Sr₂Ca₂Cu₃Oₓ besonders vorteilhaft, wenn auch im Bi-Cuprat-Umhüllungsmaterial die Bi-Komponente in entsprechender Weise durch Pb partiell substituiert ist. Der Anteil an Pb in dem Material liegt dabei im allgemeinen zwischen 10 und 40 Gew.-%. Außerdem kann die Sr-Komponente bis zu 20 Gew.-% durch Ba substituiert werden.

Die Basis-Verbindung Bi₂Sr₂CuOₓ des Umhüllungsmaterials kann desweiteren in einem weiten Zusammensetzungsbereich variieren, ohne daß sich der Verbindungstyp praktisch ändert. Dieser Zusammensetzungsbereich umfaßt ungefähr **Bi**_{1,8-2,2}Sr_{1,8-2,2}Cu_{0,8-1,2}Oₓ.

Auch im Fall des Umhüllungsmaterials mit oder aus der Basis-Verbindung (Sr_{α}Ca_{1-α})Cu_{y}O_{z} ist eine entsprechende Variation des Zusammensetzungsbereichs möglich. Dieser Zusammensetzungsbereich ist ungefähr durch 0,1 ≤ α ≤ 0,9 und 0,3 ≤ y ≤ 3 festgelegt. Als besonders vorteilhaft sind dabei folgende Zusammensetzungen anzusehen: (Sr, Ca)CuO_{z} wie z.B. das SrCaCu₂O_{z} mit z ≈ 3 oder (Sr, Ca)₂CuO_{z} oder (Sr, Ca)₁₄Cu₂₄O_{z}. Auch hierbei kann beispielsweise die Sr-Komponente bis zu 20 Gew.-% durch Ba substituiert werden. Der z-Index kann bei den einzelnen Cupraten verschieden sein.
Die genannten Umhüllungsmaterialien können mit an sich bekannten physikalischen oder chemischen Abscheidungsprozessen aufgebracht bzw. abgeschieden werden. Als ein besonders einfach auszuführendes Verfahren wird vorteilhaft eine Schmelze aus dem gewählten Umhüllungsmaterial in entsprechender Zusammensetzung vorgesehen, durch die der noch nicht umhüllte Teil des Leiterelementes 2 gezogen wird. Die Schmelze braucht nicht unbedingt aus dem fertigen, oxidischen Umhüllungsmaterial zu bestehen. Vielmehr kann sie auch aus einem Materialvorprodukt des gewünschten Umhüllungsmaterials gebildet werden. Dieses Materialvorprodukt läßt sich dann während des Ziehens der Leiterelemente durch die entsprechende Schmelze oder nach dem Ziehen durch diese Schmelze in das gewünschte Umhüllungsmaterial mittels einer Oxidationsbehandlung überführen.

Eine weitere einfache Beschichtungsmöglichkeit besteht darin, jedes nicht-umhüllte Leiterelement durch eine feinteilige Suspension aus dem Umhüllungsmaterial oder aus Metalloxiden entsprechend der gewünschten Zusammensetzung das Umhüllungsmaterials zu ziehen. Das anhaftende Oxidpulver wird danach direkt auf dem jeweiligen Leiterelement in einer kurzen Heizzone geschmolzen und bildet so eine besonders dünne und homogene Schmelzumhüllung des Leiterelementes aus. Statt des Umhüllungsmaterials oder den entsprechenden Metalloxiden ist auch ein Materialvorprodukt verwendbar, das vor dem Aufschmelzen in der Heizzone oder während des Aufschmelzens einer Oxidationsbehandlung unterzogen wird, um so das gewünschte oxidische Material zu erhalten.

Die Schmelztemperatur der Verbindung mit der stöchiometrischen Zusammensetzung Bi₂Sr₂CuOₓ beträgt etwa 840°C. Durch eine teilweise Substitution von Bi durch Pb und eine Erhöhung des Bi-Anteils gegenüber Sr und Cu läßt sich der Schmelzpunkt des Umhüllungsmaterials bis auf etwa 750°C erniedrigen. Da die Ausbildung der Hoch-T_{c}-Phase im Leiterelement bei vergleichsweise höheren Temperaturen erfolgt, ist hier keine Beeinträchtigung durch den Beschichtungsprozeß zu befürchten.

Eine weitere Reduzierung des Schmelzpunktes kann z.B. durch eine Zumischung von bis zu 50 Gew.-% Bi- und Pb-Oxid erreicht werden. Diese Oxide dienen dann als Flußmittel und werden nicht in die Basis-Verbindung Bi₂Sr₂CuOₓ eingebaut. Der Gehalt an Fremdphasen im Umhüllungsmaterial gegenüber Bi₂Sr₂CuOₓ kann bis zu 50 Gew.-% betragen.

Das in Figur 2 gezeigte Leiterelement 7 unterscheidet sich von dem Leiterelement 2 nach Figur 1 lediglich dadurch, daß statt eines kreisförmigen Querschnittes ein polygonaler Querschnitt mit Sechseckform vorgesehen ist. Mit entsprechend geformten Leiterelementen ist eine Bündelung mit besonders hoher Packungsdichte möglich.

Abweichend von den in den Figuren 1 und 2 dargestellten Ausführungsformen eines Leiterelementes 2 bzw. 7 ist auch ein Aufbau möglich, bei dem die Umhüllung 5 noch mit mindestens einer weiteren Schicht, z.B. aus dem Material der normalleitenden Ag-Hülle, umschlossen ist (vgl. die genannte WO-Schrift).

Um zu einem Mehrkernleiter zu gelangen, wird in bekannter Weise eine Bündelung von mehreren solcher Leiterelemente in einem größeren (zweiten) Hüllrohr insbesondere aus dem Matrixmaterial vorgenommen. Der so gewonnene Aufbau kann anschließend noch weiter kompaktiert und gegebenenfalls geglüht werden, bevor er in an sich bekannter Weise mittels einer weiteren Verformungs- und Glühbehandlung in das angestrebte Endprodukt überführt wird. Diese weitere Verformungs- und Glühbehandlung umfaßt dabei eine Reihe von einzelnen Schritten. Der vor diesen Schritten vorliegende Mehrkernaufbau sei nachfolgend als Mehrkernrohleiter bezeichnet. Eine entsprechende Ausführungsform eines solchen Mehrkernrohleiters ist in Figur 3 teilweise angedeutet und mit 10 bezeichnet. Der Rohleiter hat im allgemeinen eine kreisförmigen Querschnitt. Falls eine Bandform des Leiterendproduktes angestrebt ist, muß der Rohleiter einem Flachbearbeitungsprozeß mit mehreren Walzschritten und einer Wärme- und Glühbehandlung unterzogen werden, die wenigstens einen, im allgemeinen am Ende des Flachbearbeitungsprozesses vorzugsweise in einer sauerstoffhaltigen Atmosphäre wie z.B. an Luft durchzuführenden (Abschluß-)Glühschritt umfaßt. Auf diese Weise ist dem Vorproduktmaterial der für die Ausbildung der gewünschten supraleitenden Phase erforderliche Sauerstoff zur Verfügung zu stellen und/oder kann die Wiederherstellung dieser Phase gewährleistet werden, ohne daß durch die Verwendung der erfindungsgemäßen, schlecht- oder nicht-leitenden Umhüllungen 5 ein Sauerstofftransport behindert würde. In der Figur 3 sind diese Umhüllungen durch verstärkte Linien angedeutet.

Gemäß den vorstehend dargestellten Ausführungsbeispielen wurde davon ausgegangen, daß die Umhüllung 5 im allgemeinen zu 100 % aus einem der genannten oxidischen Materialien besteht. Selbstverständlich sind auch Ausführungsformen geeignet, die das gewünschte oxidische Material nur überwiegend, d.h. zu mehr als 50 Gew.-% enthalten. Der restliche Gehalt wird dann im allgemeinen von Fremdphasen, die nicht unbedingt Oxide sein müssen, eingenommen.

## Patentansprüche

1. Wechselstrom-Supraleiter mit mehreren Leiterkernen, welche jeweils
- ein Supraleitermaterial mit einer metalloxidischen Hoch-T_{c}-Phase auf Basis eines Bi-Cuprates aufweisen,
- in ein Ag zumindest enthaltendes Matrixmaterial eingebettet sind und
- von einer Umhüllung umgeben sind, die aus einem metalloxidischen Material mit einem gegenüber dem Matrixmaterial vergleichsweise größeren spezifischen elektrischen Widerstand bestehen,
**dadurch gekennzeichnet,**
**dass** als Material der Umhüllung (5) ein Bi_{1,8-2,2}Sr_{1,8-2,2}Cu_{0,8-1,2}Oₓ zumindest enthaltendes, nicht-supraleitendes Bi-Sr-Cuprat vorgesehen ist
und das Material der Umhüllung einen Gehalt an Fremdphasen von mehr als 0 Gewichtsprozent bis zu 50 Gewichtsprozent gegenüber Bi_{1,8-2,2}Sr_{1,8-2,2}Cu_{0,8-1,2}Oₓ aufweist.

2. Wechselstrom-Supraleiter nach Anspruch 1, **dadurch gekennzeichnet, daß** das Material der Umhüllung (5) einen Anteil an dem nicht-supraleitenden Bi-Sr-Cupratmaterial von mindestens 50 Gew.-% aufweist.

3. Wechselstrom-Supraleiter nach Anspruch 1 oder 2, **dadurch gekennzeichnet, daß** die Bi-Komponente des supraleitenden Bi-Cuprates und/oder des nicht-supraleitenden Bi-Sr-Cupratmaterials der Umhüllung (5) partiell durch Pb substituiert ist.

4. Wechselstrom-Supraleiter nach Anspruch 3, **dadurch gekennzeichnet, daß** 10 bis 40 Gew.-% der Bi-Komponente durch Pb substituiert sind.

5. Wechselstrom-Supraleiter mit mehreren Leiterkernen, welche jeweils
- ein Supraleitermaterial mit einer metalloxidischen Hoch-T_{c}-Phase auf Basis eines Bi-Cuprates aufweisen,
- in ein Ag zumindest enthaltendes Matrixmaterial eingebettet sind,
und
- von einer Umhüllung umgeben sind, die aus einem metalloxidischen Material mit einem gegenüber dem Matrixmaterial vergleichsweise größeren spezifischen elektrischen Widerstand bestehen,
**dadurch gekennzeichnet, daß** als Material der Umhüllung (5) ein (Sr_{α}Ca_{1-α})Cu_{y}O_{z} zumindest enthaltendes, nicht-supraleitendes Sr-Ca-Cupratmaterial vorgesehen ist, wobei gilt:
0,1 ≤ α ≤ 0,9 und 0,3 ≤ y ≤ 3.

6. Wechselstrom-Supraleiter nach Anspruch 5, **gekennzeichnet durch** ein Material der Umhüllung aus der Gruppe (Sr, Ca)CuO_{z}, (Sr, Ca)₂CuO_{z}, (Sr, Ca)₁₄Cu₂₄O_{z}, SrCaCu₂O_{z}.

7. Wechselstrom-Supraleiter nach Anspruch 5 oder 6, **dadurch gekennzeichnet, daß** das Material der Umhüllung (5) einen Anteil an dem nicht-supraleitenden Sr-Ca-Cupratmaterial von mindestens 50 Gew.-% aufweist.

8. Wechselstrom-Supraleiter nach einem der Ansprüche 1 bis 7, **dadurch gekennzeichnet, daß** die Sr-Komponente des Umhüllungsmaterials bis zu 20 Gew.-% durch Ba substituiert ist.

9. Wechselstrom-Supraleiter nach einem der Ansprüche 1 bis 8, **dadurch gekennzeichnet, daß** das Supraleitermaterial die 2223-Phase des Bi-Cuprates zumindest zu einem überwiegenden Anteil aufweist.

10. Wechselstrom-Supraleiter nach einem der Ansprüche 1 bis 9, **gekennzeichnet durch** eine Bandform.

11. Verfahren zur Herstellung eines Wechselstrom-Supraleiters nach einem der Ansprüche 1 bis 10, **dadurch gekennzeichnet, daß** Leiterelemente (2, 7) mit jeweils einem von dem Matrixmaterial (4) umgebenen Kern (3) aus einem Vormaterial des Supraleitermaterials ausgebildet werden, die einem das Vormaterial verdichtenden Verformungsprozeß und gegebenenfalls einer Glühbehandlung unterzogen werden, daß die Leiterelemente (2, 7) jeweils mit einem Überzug (5) aus dem Material der Umhüllung versehen werden, mit einem Bündel aus umhüllten Leiterelementen ein Mehrkernrohleiter (10) gebildet wird, der mittels einer anschließenden Verformungs- und Glühbehandlung in ein Leiterendprodukt überführt wird.

12. Verfahren nach Anspruch 11, **dadurch gekennzeichnet, daß** zum Überziehen der Leiterelemente (2, 7) diese durch ein Bad einer Schmelze aus dem Umhüllungsmaterial oder einem Materialvorprodukt desselben gezogen werden.

13. Verfahren nach Anspruch 12, **dadurch gekennzeichnet, daß** das Materialvorprodukt wärhend des Ziehens oder nach dem Ziehen der Leiterelemente (2, 7) durch die Schmelze einer Oxidationsbehandlung unterzogen wird.

14. Verfahren nach Anspruch 11, **dadurch gekennzeichnet, daß** zum Überziehen der Leiterelemente (2, 7) diese durch eine ein feinpulvriges Umhüllungsmaterial oder ein Materialvorprodukt desselben enthaltende Suspension gezogen werden und daß das anhaftende Pulver anschließend in einer Heizzone aufgeschmolzen wird.

15. Verfahren nach Anspruch 14, **dadurch gekennzeichnet, daß** das Materialvorprodukt vor dem Aufschmelzen in der Heizzone oder während des Aufschmelzens einer Oxidationsbehandlung unterzogen wird.

16. Verfahren nach einem der Ansprüche 11 bis 15, **dadurch gekennzeichnet, daß** die Leiterelemente (2, 7) nach einer Pulver-im-Rohr-Technik erstellt werden.

## Claims

1. An AC superconductor with several conducting cores, which respectively
- contain a superconducting material with a high T_{c} metal oxide phase based on a Bi cuprate,
- are embedded in a matrix material containing at least Ag and
- are surrounded by cladding, which consist of a metal oxide material with a comparatively larger specific electric resistance than that of the matrix material,
**characterized in that**,
a non-superconducting Bi-Sr cuprate containing at least Bi_{1.8-2.2}Sr_{1.8-2.2}Cu_{0.8-1.2}Oₓ, is provided as a material of the cladding (5),
and the material of the cladding has a foreign phase content of more than 0% by weight to 50% by weight as compared With Bi_{1.8-2.2} Sr_{1.8-2.2} CU_{0.8-1.2}Oₓ.

2. The AC superconductor according to claim 1, **characterized in that** the material of the cladding (5) has a proportion of non-superconducting Bi-Sr cuprate material of at least 50% by weight.

3. The AC superconductor according to claim 1 or 2, **characterized in that** the Bi component of the superconducting Bi cuprate and/or of the non-superconducting Bi-Sr cuprate material of the cladding (5) is partially substituted with Pb.

4. The AC superconductor according to claim 3, **characterized in that** 10 to 40% by weight of the Bi component are substituted with Pb.

5. An AC superconductor with several conducting cores, which respectively
- contain a superconducting material with a metal oxide high T_{c} phase based on Bi cuprate,
- are embedded in a matrix material containing at least Ag, and
- are surrounded by cladding, which consist of a metal oxide material with a comparatively larger specific electric resistance than that of the matrix material,
**characterized in that** a non-superconducting Sr-Ca cuprate material containing at least (Sr_{α} Ca_{1-α}) Cu_{y}O_{z} is provided, wherein:
0.1 ≤ α ≤ 0.9 and 0.3 ≤ y ≤ 3.

6. The AC superconductor according to claim 5, **characterized by** a material of the cladding from the group, (Sr,Ca)CuO_{z}, (Sr, Ca)₂CuO_{z}, (Sr, Ca)₁₄Cu₂₄O_{z}, SrCaCu₂O_{z}.

7. The AC superconductor according to claim 5 or 6, **characterized in that** the material of the cladding (5) has a proportion of non-superconducting Sr-Ca cuprate material less than 50% by weight.

8. The AC superconductor according to any of claims 1 to 7, **characterized in that** the Sr component of the cladding material is substituted with Ba in an amount up to 20% by weight.

9. The AC superconductor according to any of claims 1 to 8, **characterized in that** the superconducting material has the 2223 phase of the Bi cuprate at least in a main proportion.

10. The AC superconductor according to any of claims 1 to 9, **characterized by** a tape shape.

11. A method for making an AC superconductor according to any of claims 1 to 7, **characterized in that** conducting elements (2, 7) are each formed with one core (3) surrounded by the matrix material (4) consisting of a pre-material of the superconducting material, which undergoes a forming process compressing the pre-material and, if necessary, an annealing treatment, **in that** the conducting elements (2, 7) are each provided with a coat (5) of the material of the cladding, a multi-core raw conductor (10) is formed with a bundle of cladded conducting elements, which is transformed into a conducting final product by means of a subsequent deformation and annealing treatment.

12. The method according to claim 11, **characterized in that** for coating the conducting elements (2, 7), the latter are drawn through a molten bath of cladding material or a material pre-product of the same.

13. The method according to claim 12, **characterized in that** the material pre-product during the drawing or after the drawing of the conductor elements (2, 7) through the melts, undergoes an oxidation treatment.

14. The method according to claim 11, **characterized in that** for coating the conductor elements (2, 7), the latter are drawn through a suspension containing a finely powdered cladding material or a material pre-product of the same and that the adhering powder is subsequently melted in a heated area.

15. The method according to claim 14, **characterized in that** the material pre-product undergoes an oxidation treatment before melting in the heated area or during the melting.

16. The method according to any of claims 11 to 15, **characterized in that** the conducting elements (2, 7) are produced according to a powder-in-tube technique.

## Revendications

1. Supraconducteur à courant alternatif avec plusieurs âmes conductrices qui, respectivement,
- présentent un matériau supraconducteur avec une phase oxyde métallique à haute T_{c} à base d'un cuprate de Bi,
- sont noyées dans un matériau de matrice contenant au moins de l'Ag, et
- sont entourées par une enveloppe qui se compose d'un matériau en oxyde métallique qui possède une résistance électrique spécifique comparativement plus élevée que celle du matériau de matrice,
**caractérisé en ce qu'**il est prévu en tant que matériau de l'enveloppe (5) un cuprate de Bi-Sr non supraconducteur contenant au moins du Bi_{1,8-2,2}Sr_{1,8-2,2}Cu_{0,8-1,2}Oₓ et **en ce que** le matériau de l'enveloppe présente une teneur en phases étrangères allant de plus de 0% en poids jusqu'à 50% en poids par rapport au Bi_{1,8-2,2}Sr_{1,8-2,2}Cu_{0,8-1,2}Oₓ.

2. Supraconducteur à courant alternatif selon la revendication 1, **caractérisé en ce que** le matériau de l'enveloppe (5) présente une teneur en matériau cuprate de Bi-Sr non supraconducteur d'au moins 50% en poids.

3. Supraconducteur à courant alternatif selon la revendication 1 ou la revendication 2, **caractérisé en ce que** le composant Bi du cuprate de Bi supraconducteur et/ou du matériau cuprate de Bi-Sr non supraconducteur de l'enveloppe (5) est remplacé en partie par du Pb.

4. Supraconducteur à courant alternatif selon la revendication 3, **caractérisé en ce que** 10 à 40% en poids du composant Bi sont remplacés par du Pb.

5. Supraconducteur à courant alternatif avec plusieurs âmes conductrices qui, respectivement,
- présentent un matériau supraconducteur avec une phase oxyde métallique à haute T_{c} à base d'un cuprate de Bi,
- sont noyées dans un matériau de matrice contenant au moins de l'Ag, et
- sont entourées d'une enveloppe qui se compose d'un matériau en oxyde métallique qui possède une résistance électrique spécifique comparativement plus élevée que celle du matériau de matrice,
**caractérisé en ce qu'**il est prévu en tant que matériau de l'enveloppe (5) un matériau cuprate de Sr-Ca non supraconducteur contenant au moins du (Sr_{α}Ca_{1-α}) Cu_{y}O_{z}, avec 0, 1 ≤ α ≤ 0,9 et 0,3 ≤ y ≤ 3.

6. Supraconducteur à courant alternatif selon la revendication 5, **caractérisé en ce que** le matériau de l'enveloppe est choisi dans le groupe (Sr, Ca) CuO_{z}, (Sr, Ca)₂CuO_{z}, (Sr, Ca)₁₄Cu₂₄O_{z}, SrCaCu₂O_{z} .

7. Supraconducteur à courant alternatif selon la revendication 5 ou la revendication 6, **caractérisé en ce que** le matériau de l'enveloppe (5) présente une teneur en matériau cuprate de Sr-Ca non supraconducteur d'au moins 50% en poids.

8. Supraconducteur à courant alternatif selon l'une des revendications 1 à 7, **caractérisé en ce que** le composant Sr du matériau de l'enveloppe est remplacé jusqu'à 20% en poids par du Ba.

9. Supraconducteur à courant alternatif selon l'une des revendications 1 à 8, **caractérisé en ce que** le matériau supraconducteur présente la phase 2223 du cuprate de Bi au moins en une proportion majoritaire.

10. Supraconducteur à courant alternatif selon l'une des revendications 1 à 9, **caractérisé par** une forme de bande.

11. Procédé de fabrication d'un supraconducteur à courant alternatif selon l'une des revendications 1 à 10, **caractérisé en ce que** les éléments conducteurs (2, 7) sont réalisés chacun avec une âme (3) entourée par le matériau de matrice (4) à partir d'un matériau de départ du matériau supraconducteur qui est soumis à un processus de transformation qui comprime le matériau de départ et le cas échéant à un traitement de recuit, les éléments conducteurs (2, 7) sont dotés chacun d'un revêtement (5) avec le matériau de l'enveloppe, un conducteur à âmes multiples brut (10) est formé avec un faisceau d'éléments conducteurs enveloppés et ensuite transformé par un traitement de déformation et de recuit en un produit conducteur final.

12. Procédé selon la revendication 11, **caractérisé en ce que** le revêtement des éléments conducteurs (2, 7) se fait en les faisant passer dans un bain contenant une fusion du matériau d'enveloppe ou d'un précurseur de celui-ci.

13. Procédé selon la revendication 12, **caractérisé en ce que** le matériau précurseur est soumis à un traitement d'oxydation pendant ou après le passage des éléments conducteurs (2, 7) dans la fusion.

14. Procédé selon la revendication 11, **caractérisé en ce que** le revêtement des éléments conducteurs (2, 7) se fait en les faisant passer dans une suspension contenant un matériau d'enveloppe en poudre fine ou un précurseur de celui-ci et **en ce que** la poudre adhérente est ensuite fondue dans une zone de chauffage.

15. Procédé selon la revendication 14, **caractérisé en ce que** le matériau précurseur est soumis à un traitement d'oxydation avant ou pendant la fusion dans la zone de chauffage.

16. Procédé selon l'une des revendications 11 à 15, **caractérisé en ce que** les éléments conducteurs (2, 7) sont fabriqués suivant une technique poudre dans tube.
